# EUROPEAN PATENT APPLICATION

(11) **EP 2 444 844 A2**
(43) Date of publication of application: **25.04.2012**
(21) Application number: 11184047.6
(22) Date of filing: 05.10.2011
(51) Int. Cl.: G03F 7/00, G03F 7/34, H05K 3/20

(54) **Pattern transfer method and apparatus therefor**

(30) Priority: 22.10.2010 KR 20100103480; 22.10.2010 KR 20100103485
(71) Applicant: Korea Advanced Institute Of Science And Technology, Daejeon 305-701 (KR)
(72) Inventor: Yang, Minyang, 305-701 Daejeon (KR); Kang, Bongchul, 305-701 Daejeon (KR)
(74) Representative: Flügel Preissner Kastel Schober

(57) **Abstract**

The present invention relates to methods and apparatuses for transferring pattern, a flexible display panel, a flexible solar cell, an electronic book, a thin film transistor, an electromagnetic-shielding sheet, and a flexible printed circuit board applying thereof. A pattern transfer method related to the present invention comprises: a first step of forming a pattern material on a substrate; a second step of hardening the pattern material in the solid state; a third step of patterning the pattern material by irradiating a laser beam to the hardened pattern material in the solid state; and a fourth step of pressing the patterned pattern material in the solid state and a flexible substrate facing each other and transferring the pattern material to the flexible substrate by a viscous force of the flexible substrate occurring in a facing part between the pattern material and the flexible substrate by irradiating the laser beam from the pattern material to the flexible substrate or from the flexible substrate to the pattern material.

## Description

### BACKGROUND OF THE INVENTION

### Field of the Invention

The present invention relates to pattern transfer methods and apparatuses, a flexible display panel, a flexible solar cell, an electronic book, a thin film transistor, an electromagnetic-shielding sheet, and a flexible printed circuit board applying thereof.

### Description of the Related Art

Recently, a demand for thin films and high performance of a product has been increasing in a lighting device industry, a display industry, a semiconductor industry, and a bio industry. To meet the requirements, wires or functional thin film layers constituting respective components should form a pattern uniformly and much smaller. Accordingly, a method for manufacturing a fine pattern is a base technique of the industries.

in general, there are photolithography, Fine Mask Deposition (FMD), printing, Nano Imprinting Lithography (NIL), Micro Contact Printing (MCP), Laser Assisted Pattern Transfer (LAPT), and Laser direct patterning as examples of a conventional method for manufacturing a pattern with the size less than mico-meter. However, the conventional manufacturing methods have their own limitations in the process respectively.

First, in the photolithography, a manufacturing process is complicated, it is difficult to manufacture a shadow mask, a manufacturing cost is high, and precision is deteriorated due to distortion of a mask. Furthermore, it is difficult to align the mask and a target, and to change a process, namely, to change the size and the shape of a pattern.

Second, the FMD has the same problems associated with the shadow mask described in the photolithography and a problem that a manufacturing cost is high. Furthermore, the FMD has problems such as material limitation and long manufacturing time.

Third, because the material manufacturing a pattern should be a liquid solution state in an ink-jet type in the printing, various materials cannot be used. Because it is difficult to inject a solution uniformly, a non-uniform pattern is produced. Further, when a substrate having a pattern to be transferred is a flexible substrate, because the flexible substrate is decomposed by heat at the time of ink sintering, sintering temperature is restricted. Accordingly, an ink-jet type is not suitable to be used in a substrate such as PET having low thermal resistance. Moreover, to let the substrate soak in a droplet, there is a need for a surface treatment.

Fourth, a roll to roll scheme in the printing scheme has an advantage that is applicable to only a case of manufacturing a relatively large pattern of approximately 30~40 µm and manufacturing speed of a pattern is high. However, since a roll type mold has a pattern of a geometric shape, it is difficult to manufacture the mold. A material of the pattern material remains in a groove to deteriorate transfer efficiency. Moreover, an additional process such as surface treatment is required to increase transfer efficiency. Since the pattern material is transferred to a liquid state, a pattern boundary is indefinite and it is significantly affected by change in a peripheral environment (temperature, moisture).

Fifth, since the NIL scheme performs patterning through etching using photoresist (PR), it is not a direct patterning scheme and a PR remains to complicate a procedure for manufacturing a pattern and surface treatment is required to easily space a mold.

Sixth, the MCP may manufacture a wide pattern of several tens µm ~ several tens nm. However, it require a flexible mold, an additional process for manufacturing the flexible mold, and the flexible mold can be changed at the time of pressurization. Furthermore, it is difficult to form a uniform pattern of a large area and there is a need for an additional process (surface treatment) to increase transfer efficiency.

Seventh, because the LAPT forms a pattern in only a place irradiated by a laser, it takes a long time to manufacture a large-area pattern. Because a boundary of a pattern is cut by laser to disperse particles on a substrate, the boundary of a pattern is more non-uniform than that of other processes.

Finally, in the laser direct patterning, when laser is directly irradiated to a flexible substrate, the flexible substrate is easily damaged due to low thermal resistance thereof. Accordingly, an applicable substrate is restricted. Since the laser should be irradiated to all patterns, it is not suitable to mass production of a pattern. In the meantime, there is an embodiment that laser is directly irradiated to a flexible substrate using a metal ink formed of particles having lower melting point of several nm. Since the ink is very high cost, a manufacturing is expensive and there is a limitation to materials available to a process for manufacturing the pattern.

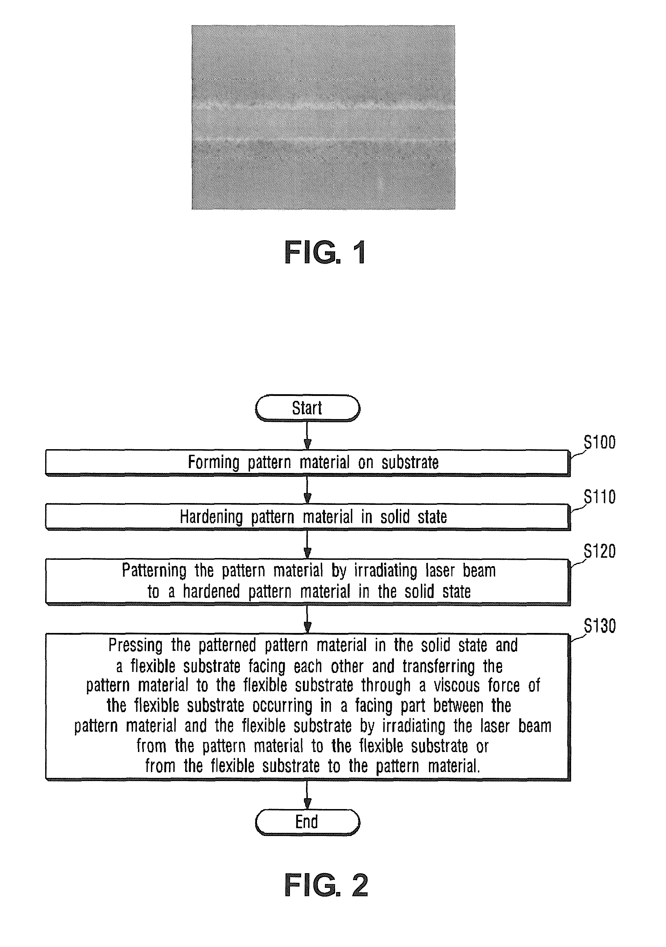

FIG. 1 is a photograph describing a pattern transferred by a pattern transfer method according to prior art. FIG. 1 is a pattern transferred using LAPT. Referring to FIG. 1, a boundary of the pattern transferred using the LAPT is cut by a laser and it results in scattering particles around the pattern. Accordingly, because LAPT scatters particles around the pattern, it has a problem that a boundary of the pattern is no uniform.

Meanwhile, it is impossible to directly irradiate a laser beam to a flexible substrate to be patterned. The reason is because a flexible substrate is easily damaged due to a low melting point thereof when a laser beam is directly irradiated to the flexible substrate. Of course, there is a case of patterning a flexible substrate by irradiating a laser beam to a flexible substrate using a metal ink composed of a particle of several nm having a low melting point as a transfer material. However, in this case, the variation of transferring materials is limited. Furthermore, because this metal ink is a very expensive, the cost of manufacturing the pattern is high.

In addition, when this transfer material is transferred on a substrate, an adhesion force between the transfer material and the substrate is weak. Accordingly, the transfer material is easily peeled or snapped due to a movement of the flexible substrate.

### SUMMARY OF THE INVENTION

The present invention is conceived to solve the aforementioned problems. Accordingly, the present invention provides pattern transfer methods and apparatuses, a flexible display panel, a flexible solar cell, an electronic book, a thin film transistor, an electromagnetic-shielding sheet, and a flexible printed circuit board applying thereof that may press a pattern material hardened in the solid state patterned on a substrate and a flexible substrate facing each other, transfer transfer material in the solid state on a flexible substrate by a viscous force of the flexible substrate occurred by irradiating the laser beam to a facing part between the patterned pattern material and the flexible substrate, thereby transferring a pattern on the flexible substrate, having a clear boundary of the transferred pattern, and uniformly forming a pattern on a large area.

The present invention also provides pattern transfer methods and apparatuses, a flexible display panel, a flexible solar cell, an electronic book, a thin film transistor, an electromagnetic-shielding sheet, and a flexible printed circuit board applying thereof that may manufacture a pattern strongly adhered to a flexible substrate without a separate adhesive layer by directly transferring a patterned pattern material on the flexible substrate by a viscosity force occurring in the flexible substrate and simplify the pattern manufacturing processes.

The present invention also provides pattern transfer methods and apparatuses, a flexible display panel, a flexible solar cell, an electronic book, a thin film transistor, an electromagnetic-shielding sheet, and a flexible printed circuit board applying thereof that may perform a continuous transferring process by transferring a transfer material patterned on a substrate on a flexible substrate wound around a roll using a laser beam while moving the substrate.

The present invention also provides pattern transfer methods and apparatuses, a flexible display panel, a flexible solar cell, an electronic book, a thin film transistor, an electromagnetic-shielding sheet, and a flexible printed circuit board applying thereof that may rapidly manufacture a pattern without using a mask and easily change a manufacturing process.

The present invention also provides pattern transfer methods and apparatuses, a flexible display panel, a flexible solar cell, an electronic book, a thin film transistor, an electromagnetic-shielding sheet, and a flexible printed circuit board applying thereof that may manufacture a pattern having strong durability by transferring a pattern material in the solid state on a flexible substrate.

The present invention also provides a pattern transfer method suitable to mass production of a pattern.

The present invention also provides a pattern transfer method capable of rapidly manufacturing a pattern at a low manufacturing cost.

The present invention also provides a pattern transfer method in which a substrate on which a pattern is transferred is not transformed by heat.

The present invention also provides a pattern transfer method in which patterning is possible in a substrate having low thermal resistance.

The present invention also provides a pattern transfer method in which uniformity of a boundary of a transferred pattern is improved.

The present invention also provides a pattern transfer method in which the size and quality of a pattern is not changed according to environment variation.

The present invention also provides a pattern transfer method capable of easily changing a thickness of a pattern.

The present invention also provides a pattern transfer method capable of manufacturing a pattern smaller than the size of a laser focus.

The present invention also provides a pattern transfer method suitable to mass production by patterning it on a target substrate using a surface mold selectively coated with ink not to directly pattern it on the target substrate using laser.

Concepts and preferred embodiments of the invention are indicated in the following clauses:

Clause 1: A pattern transfer method, comprising:
a first step of forming a pattern material on a substrate;
a second step of hardening the pattern material in the solid state;
a third step of patterning the pattern material by irradiating a laser beam to the hardened pattern material in the solid state; and
a fourth step of pressing the patterned pattern material in the solid state and a flexible substrate facing each other and transferring the patterned pattern material to the flexible substrate by a viscous force of the flexible substrate occurring in a facing part between the patterned pattern material and the flexible substrate by irradiating the laser beam from the patterned pattern material to the flexible substrate or from the flexible substrate to the patterned pattern material.

Clause 2: A pattern transfer method, comprising:
a first step of forming a pattern material on a substrate;
a second step of hardening a predetermined area of the pattern material in the solid state by irradiating a laser beam to the predetermined area of the pattern material;
a third step of removing a remaining area of the pattern material except for the predetermined area of the pattern material by an organic solvent;
a fourth step of re-hardening the predetermined area of the pattern material in the solid state; and a fifth step of pressing the re-hardened pattern material in the solid state and a flexible substrate facing each other and transferring the re-hardened pattern material to the flexible substrate by a viscous force of the flexible substrate occurring in a facing part between the re-hardened pattern material and the flexible substrate by irradiating the laser beam from the re-hardened pattern material to the flexible substrate or from the flexible substrate to the re-hardened pattern material.

Clause 3: A pattern transfer apparatus comprising:
a flexible substrate whose one side is wound around a roll and having a polymer material;
a substrate disposed to be pressed facing a lower portion of the flexible substrate, and patterned by a laser beam after a pattern material formed on an upper surface of the substrate is hardened in the solid state;
a moving unit disposed at a lower surface of the substrate and moving the substrate; and a laser irradiating unit irradiating a laser beam from the moving unit to a direction of the flexible substrate,
   wherein the flexible substrate and the substrate are pressed facing each other as the substrate moves by the moving unit, and the pattern material is transferred to the flexible substrate by a viscous force of the flexible substrate occurred in a facing part between the pattern material and the flexible substrate by the laser beam from the laser irradiating unit.

Clause 4: The pattern transfer apparatus according to clause 3, wherein the laser irradiating unit irradiates a fine beam as the laser beam.

Clause 5: A pattern transfer method, comprising:
a first step of forming a hydrophobic coating layer on a substrate and selectively removing the hydrophobic coating layer using laser application plasma to form a surface mold;
a second step of forming a pattern by coating and drying a pattern material on the surface mold, and then by sintering the surface mold at a high temperature; and
a third step of pressing the surface mold and a target substrate facing each other and transferring the pattern material to the target substrate by a viscous force of the target substrate occurring in a facing part between the pattern material on the surface mold and the target substrate by irradiating the laser beam from the surface mold to the target substrate or from the target substrate to the surface mold.

Clause 6: The pattern transfer method according to clause 5, wherein the first step comprises:
a step of forming the hydrophobic coating layer on the substrate;
a step of coating a plasma generation layer on the hydrophobic coating layer;
a step of selectively removing the hydrophobic coating layer by irradiating a laser beam from the substrate to the plasma generation layer; and
a step of removing the plasma generation layer.

Clause 7: The pattern transfer method of any of clauses 5 or 6, wherein the pattern material used in the second step is a hydrophilic organic metal ink.

Clause 8: A pattern transfer apparatus comprising:
a flexible substrate including a polymer material, one side of the flexible substrate wound by a roll;
a substrate coated with a pattern material after selectively removing a hydrophobic coating layer formed on a upper surface of the substrate, and pressurized to face a lower portion of the flexible substrate;
a moving unit provided at a lower surface of the substrate and moving the substrate; and
a laser irradiating unit irradiating laser from the substrate to the flexible substrate or from the flexible substrate to the substrate,
   wherein the moving unit operates to move the substrate, thereby pressurizing the flexible substrate and the substrate to face each other, and the pattern material is transferred on the flexible substrate due to a viscous force of the flexible substrate occurring at a facing part between the pattern material and the flexible substrate by the laser from the laser irradiating unit.

Clause 9: A flexible display panel comprising an electrode formed by a pattern transferred by the pattern transfer method described in any one of the preceding clauses, especially in any of the clauses 1, 2 and 5.

Clause 10: A flexible solar cell comprising an electrode formed by a pattern transferred by the pattern transfer method described in any one of the preceding clauses, especially in any of the clauses 1, 2 and 5.

Clause 11: An electronic book comprising an electrode formed by a pattern transferred by the pattern transfer method described in any one of the preceding clauses, especially in any of the clauses 1, 2 and 5.

Clause 12: An electromagnetic shielding sheet comprising a pattern transferred by the pattern transfer method described in any one of the preceding clauses, especially in any of the clauses 1, 2 and 5.

Clause 13: A thin film transistor comprising a gate electrode, a source electrode, and a drain electrode formed by a pattern transferred by the pattern transfer method described in any one of the preceding clauses, especially in any of the clauses 1, 2 and 5.

Clause 14: A flexible printed circuit board comprising a conductive wiring formed by a pattern transferred by the pattern transfer method described in any one of the preceding clauses, especially in any of the clauses 1, 2 and 5.

A pattern transfer method related according to a first aspect of the invention comprises: a first step of forming a pattern material on a substrate; a second step of hardening the pattern material in the solid state; a third step of patterning the pattern material by irradiating a laser beam to the hardened pattern material in the solid state; and a fourth step of pressing the patterned pattern material in the solid state and a flexible substrate facing each other and transferring the pattern material to the flexible substrate by a viscous force of the flexible substrate occurring in a facing part between the pattern material and the flexible substrate by irradiating the laser beam from the Ipattern material to the flexible substrate or from the flexible substrate to the pattern material.

Accordingly, according to the pattern transfer method related to the first aspect of the invention, a pattern material hardened in the solid state patterned on a substrate and a flexible substrate are pressed facing each other, and the laser beam is irradiated to a facing part between the patterned pattern material and the flexible substrate, and transfer material in the solid state is transferred to a flexible substrate by a viscous force of the flexible substrate occurred by the irradiation, thereby pattern can be transferred on the flexible substrates, the boundary of the transferred pattern is clear, and a pattern can be formed uniformly on a large area.

A pattern transfer method according to a second aspect of the invention comprises a first step of forming a pattern material on a substrate; a second step of hardening the predetermined area of the pattern material in the solid state by irradiating a laser beam to a predetermined area of the pattern material. a third step of removing a remaining area of the pattern material except for the predetermined area of the pattern material by an organic solvent; a fourth step of re-hardening the predetermined area of the pattern material in the solid state; and a fifth step of pressing the re-hardened pattern material in the solid state and a flexible substrate facing each other and transferring the pattern material to a flexible substrate by a viscous force of the flexible substrate occurring in a facing part between the pattern material and the flexible substrate by irradiating the laser beam from the pattern material to the flexible substrate or from the flexible substrate to the pattern material.

Accordingly, according to the pattern transfer method related to the second aspect of the invention, a pattern material hardened in the solid state and a flexible substrate are pressed facing each other, and the laser beam is irradiated to a facing part between the patterned pattern material and the flexible substrate, transfer material in the solid state can be transferred on a flexible substrate by a viscous force of the flexible substrate occurred by the irradiation, thereby a pattern can be transferred on the flexible substrate using laser, the boundary of the transferred pattern is clear, and a pattern can be formed uniformly on a large area.

A pattern transfer apparatus according to a third aspect of the invention comprises: a flexible substrate whose one side is wound around a roll and having a polymer material; a substrate disposed to be pressed facing a lower portion of the flexible substrate, and patterned by a laser beam after a pattern material formed on an upper surface of the substrate is hardened in the solid state; a moving unit disposed at a lower surface of the substrate and moving the substrate; and a laser irradiating unit irradiating a laser beam from the moving unit to a direction of the flexible substrate, wherein the flexible substrate and the substrate are pressed facing each other as the substrate moves by the moving unit, and the pattern material is transferred to the flexible substrate by a viscous force of the flexible substrate occurred in a facing part between the pattern material and the flexible substrate by irradiation of the laser beam from the laser irradiating unit.

Accordingly, according to the pattern transfer apparatus related to the third aspect of the invention, the apparatus a pattern material hardened in the solid state patterned on a substrate and a flexible substrate are pressed facing each other, and the laser beam is irradiated to a facing part between the patterned pattern material and the flexible substrate, transfer material in the solid state is transferred on a flexible substrate by a viscous force of the flexible substrate occurred by the irradiation, thereby pattern can be transferred on the flexible substrates, the boundary of the transferred pattern is clear, and a pattern can be formed uniformly on a large area. Further, according to the pattern transfer apparatus, the apparatus may perform a continuous transferring process because the apparatus transfers a pattern material patterned on a substrate on a flexible substrate wound around a roll using a laser beam while moving the substrate.

A pattern transfer apparatus related to a fourth aspect of the invention is the pattern transfer apparatus of the third aspect, wherein the laser irradiating unit irradiates a line beam as the laser beam.

Accordingly, according to the pattern transfer apparatus of the fourth aspect of the invention, since the laser beam is irradiated as the line beam, it can transfer a specific part of a transfer material in the patterned transfer material on the substrate.

A pattern transfer method related a fifth aspect of the invention, comprises: a first step of forming a hydrophobic coating layer on a substrate and selectively removing the hydrophobic coating layer using laser application plasma to form a surface mold; a second step of forming a pattern by coating and drying a pattern material on the surface mold, and then by sintering the surface mold at a high temperature; and a third step of pressing the surface mold and a target substrate facing each other and transferring the pattern material to the target substrate by a viscous force of the target substrate occurring in a facing part between the pattern material on the surface mold and the target substrate by irradiating the laser beam from the surface mold to the target substrate or from the target substrate to the surface mold.

Accordingly, according to the pattern transfer method of the fifth aspect, because laser application plasma is used, a pattern smaller than a laser focus can be manufactured. Further, because a surface mold coated with a pattern material is used, the same pattern as a pattern to be finally transferred can be formed by only coating the surface mold with the pattern material, a pattern manufacturing cost is cheap and pattern manufacturing speed is high. Moreover, because laser is irradiated from the surface mold to a target substrate or from the target substrate to the surface mold, patterning is possible at a target substrate with low thermal resistance. In addition, it is profitable to repeatedly manifesting the same pattern.

A pattern transfer method related to a sixth aspect of the invention is the pattern transfer method of the fifth aspect, wherein the first step comprises: a step of forming the hydrophobic coating layer on the substrate; a step of coating a plasma generation layer on the hydrophobic coating layer; a step of selectively removing the hydrophobic coating layer by irradiating a laser beam from the substrate to the plasma generation layer; and a step of removing the plasma generation layer.

According to the pattern transfer method of the sixth aspect, since the hydrophobic coating layer is instantaneously removed by strong plasma plume, it is possible to remove the hydrophobic coating layer smaller than the spot size of laser by adjusting the size of the plasma.

A pattern transfer method according to a seventh aspect of the invention is the pattern transfer method of the fifth or of the sixth aspect, wherein the pattern material used in the second step is a hydrophilic organic metal ink.

Accordingly, according to the pattern transfer method of the seventh aspect, the pattern material is easily adhered to a hydrophobic substrate to further improve a boundary and uniformity of the pattern.

A pattern transfer apparatus according to an eighth aspect of the invention, comprises: a flexible substrate including a polymer material, one side of the flexible substrate wound by a roll; a substrate coated with a pattern material after selectively removing a hydrophobic coating layer formed on a upper surface of the substrate, and pressurized to face a lower portion of the flexible substrate; a moving unit provided at a lower surface of the substrate and moving the substrate; and a laser irradiating unit irradiating laser from the substrate to the flexible substrate or from the flexible substrate to the substrate, wherein the moving unit operates to move the substrate, thereby pressurizing the flexible substrate and the substrate to face each other, and the pattern material is transferred on the flexible substrate due to a viscous force of the flexible substrate occurring at a facing part between the pattern material and the flexible substrate by the laser from the laser irradiating unit.

Accordingly, according to the pattern transfer apparatus of the eighth aspect, the substrate coated with a pattern material and a flexible substrate are pressurized to face each other, and laser is irradiated to a facing part between the pattern material and the flexible substrate. Because a pattern material is transferred on the flexible substrate due to a viscous force of the flexible substrate generated at this time, a pattern can be transferred on the flexible substrate using the laser. A boundary of a pattern transferred on the flexible substrate is clear and a pattern can be uniformly transferred on a large area.

In addition, according to the pattern transfer apparatus, since a pattern material coated on a substrate is transferred on a flexible substrate wound by a roll using laser while moving a substrate, a continuous transfer process can be executed.

A flexible display panel related to a ninth aspect of the invention comprises an electrode formed by a pattern transferred by the pattern transfer method described in any of the preceding aspects, especially in the first, the second and/or the fifth aspects.

Accordingly, according to the flexible display panel related to the ninth aspect, a boundary of an electrode wiring is clear, and a flexible display panel with a uniform electrode wiring can be provided.

A flexible solar cell related to a tenth aspect of the invention comprises an electrode formed by a pattern transferred by the pattern transfer method described in any of the preceding aspects, especially as related to any of the first, second or fifth aspects.

In the flexible solar cell related to the tenth aspect, accordingly, a boundary of the electrode wiring is clear and a flexible solar cell with with a uniform electrode wiring can be provided.

An electronic book related to an eleventh aspect of the invention comprises an electrode formed by a pattern transferred by the pattern transfer method described in any of the preceding aspects, especially by the pattern transfer method of any of the first, second or fifth aspects.

In the electronic book related to the eleventh aspect, accordingly, a boundary of the electrode wiring is clear and an electronic book with with a uniform electrode wiring can be provided.

An electromagnetic shielding sheet related to a twelfth aspect comprises a pattern transferred by the pattern transfer method described in any of the preceding aspects, especially by the transfer method of any of the first, second or fifth aspects.

In the electromagnetic shielding sheet related to the twelfth aspect, accordingly, a boundary of the pattern transferred on a film for the electromagnetic shielding sheet is clear and an electromagnetic shielding sheet with with a uniform electrode wiring can be provided.

A thin film transistor related to a thirteenth aspect comprises a gate electrode, a source electrode, and a drain electrode formed by a pattern transferred by the pattern transfer method described in any of the preceding aspects, especially by the pattern transfer method of any of the first, second or fifth aspects.

In the thin film transistor related to the thirteenth aspect, accordingly, a boundary of the electrode wiring is clear and a thin film transistor with a uniform electrode wiring can be provided.

A flexible printed circuit board related to a fourteenth aspect comprises a conductive wiring formed by a pattern transferred by the pattern transfer method described in any of the preceding aspects, especially by the pattern transfer method according to any of the first, second or fifth aspects.

In the flexible printed circuit board related to the fourteenth aspect, accordingly, a boundary of the electrode wiring is clear and a flexible printed circuit board with a uniform electrode wiring can be provided.

According to the present invention configured as described above, a pattern material hardened in the solid state patterned on a substrate and a flexible substrate are pressed facing each other, and the laser beam is irradiated to a facing part between the patterned pattern material and the flexible substrate, and transfer material in the solid state is transferred on a flexible substrate by a viscous force of the flexible substrate occurred by the irradiation, thereby pattern can be transferred on the flexible substrates using a laser, the boundary of the transferred pattern is clear, and a pattern can be formed uniformly on a large area.

Further, according to the present invention, since a pattern material patterned by a viscosity force occurring in the flexible substrate is transferred directly on the flexible substrate, a pattern strongly adhered to a flexible substrate can be manufactured without a separate adhesive layer and the pattern manufacturing processes can be simplified.

Moreover, according to the present invention, since a pattern material patterned on a substrate is patterned on a flexible substrate wound around a roll using a laser beam while moving the substrate, a continuous transfer process can be performed.

Moreover, according to the present invention, a pattern can be manufactured rapidly without using a mask, and changing a manufacturing process is easy.

Moreover, according to the present invention, since pattern material in the solid state is transferred on a flexible substrate, a pattern having a strong durability can be manufactured.

According to the present invention, it provides a pattern transfer method suitable to mass production of a pattern.

According to the present invention, it may further provide a pattern transfer method capable of rapidly manufacturing a pattern at a low cost.

According to the present invention, it may further provide a pattern transfer method in which a substrate on which a pattern is transferred is not transformed by heat.

According to the present invention, it may further provide a pattern transfer method in which patterning is possible in a substrate having low thermal resistance.

According to the present invention, it may further provide a pattern transfer method in which uniformity of a boundary of a transferred pattern is improved.

According to the present invention, it may also provide a pattern transfer method in which the size and quality of a pattern is not changed according to environment variation.

According to the present invention, it may also provide a pattern transfer method capable of easily changing a thickness of a pattern.

According to the present invention, it may also provide a pattern transfer method capable of manufacturing a pattern smaller than the size of a laser focus.

According to the present invention, it may also provide a pattern transfer method suitable to mass production by patterning it on a target substrate using a surface mold selectively coated with ink not to directly pattern it on the target substrate using laser.

The objects, constructions and effects of the present invention are included in the following embodiments and drawings. The advantages, features, and achieving methods of the present invention will be more apparent from the following detailed description in conjunction with embodiments and the accompanying drawings. The same reference numerals are used throughout the drawings to refer to the same or like parts.

### BRIEF DESCRIPTION OF THE DRAWINGS

The above and other features and advantages of the present invention will become more apparent to those of ordinary skill in the art by describing in detail preferred embodiments thereof with reference to the attached drawings, in which:

FIG. 1 is a photograph describing a pattern transferred by a pattern transfer method according to the prior art;

FIG. 2 is a flow chart describing a pattern transfer method according to a first embodiment of the present invention;

FIG. 3a to FIG. 3d are drawings describing respective steps of the pattern transfer method shown in FIG. 2;

FIG. 4 is a flow chart describing a pattern transfer method according to a second embodiment of the present invention;

FIG. 5a to FIG. 5e are drawings describing respective steps of the pattern transfer method shown in FIG. 4;

FIG. 6 is a drawing describing a pattern transferred on a flexible substrate using the pattern transfer method shown in FIG. 2;

FIG. 7 is a drawing describing a pattern transferring apparatus according to a third embodiment of the present invention.

FIG. 8 is a flow chart illustrating a pattern transfer method according to a fourth embodiment of the present invention;

FIG. 9 is a view illustrating a series of procedures transferring a pattern according to a fourth embodiment of the present invention;

FIG 10. shows a series of procedures transferring a pattern by delicately dividing the step forming the (b) the first step of the fourth embodiment of the present invention.

FIG. 11 is a view illustrating a principle that a pattern material is transferred from a substrate to a flexible substrate according to a fourth embodiment of the present invention; and

FIG. 12 is a view illustrating a pattern transfer apparatus that may continue pattern transfer using a pattern transfer method according to a fourth embodiment of the present invention.

### DETAILED DESCRIPTION OF THE PREFERRED EMBODIMENTS

Hereinafter, Hereinafter, a preferred embodiment of the present invention will be described in detail referring to the accompanying drawings. The accompanying drawings is only for explaining the present invention easier, therefore, a person of ordinary skill in the art may know that the scope of the present invention is not limited to the scope of drawings obviously.

FIG. 2 is a flow chart describing a pattern transfer method according to a first embodiment of the present invention. FIG. 2 describes a positive type peeling a part irradiated by a laser beam when an opening of a pattern is not wide to pattern a pattern material. Meanwhile, a substrate 100 is not deformed or damaged due to heat like glass although a transfer material is peeled by irradiation of the laser beam. The substrate 100 is commonly used in following a first embodiment to a third embodiment of the present invention.

Referring to FIG. 2, a pattern transfer method according to a first embodiment of the present invention comprises: a first step of forming a pattern material on a substrate 100 (S100); a second step of hardening the pattern material in the solid state (S110); a third step of patterning the pattern material by irradiating a laser beam to the hardened pattern material in the solid state (S120); and a fourth step of pressing the patterned pattern material in the solid state and a flexible substrate 200 facing each other and transferring the pattern material to the flexible substrate 200 by a viscous force of the flexible substrate 200 occurring in a facing part between the pattern material and the flexible substrate 200 by irradiating the laser beam from the pattern material to the flexible substrate 200 or from the flexible substrate 200to the pattern material(S130).

The first step (S100) is a step of forming a pattern material on a substrate 100, and coats a hard substrate (hereinafter, it is called as 'substrate') like glass with ink in the liquid state or metal paste. In this case, there are spin coating, blading coating, slit coating, electro plating, or deposition, etc. as methods for forming the pattern material in the first step (S100). Meanwhile, in the first step (S100), according to a type of a transfer material, adhesion characteristic between the transfer material and the substrate, coating characteristic of the transfer material, it is fine that substrate is firstly coated with a parting agent, and then the transfer material is formed before the formation of the pattern material. Further, when the transfer material is in the liquid state, the transfer material is hardened in such a way that only solvents in the liquid state are vaporized and nano-particles in the solid state remain therein using heat from 100°C to 200°C. Otherwise, the transfer material in the liquid state is dried in atmosphere to be hardened. There is a metal paste composed of nano- or micro-particles as a transfer material forming the pattern material. An embodiment of the present invention has been described that the transfer material forming the pattern material is the metal paste composed of nano- or micro-particles. However, the present invention is not limited thereto. Metal materials, organic materials, inorganic materials, ceramic materials, a bio material including proteins or cells can be used as the transfer material. All materials having heat conductivity higher than that of a flexible substrate 200 can be used as a transfer material of the present invention.

The second step (S110) is a step of hardening the pattern material in the solid state. The second step (S110) hardens the pattern material patterned on the substrate in the solid state in atmosphere. When a transfer material forming the pattern material patterned on a substrate is in the liquid state, the second step (S110) may apply heat from 50°C to 200°C to the transfer material in the liquid state to harden the transfer material in the solid state in such a way that only solvents in the liquid state are vaporized and nano-particles in a transfer material remain.

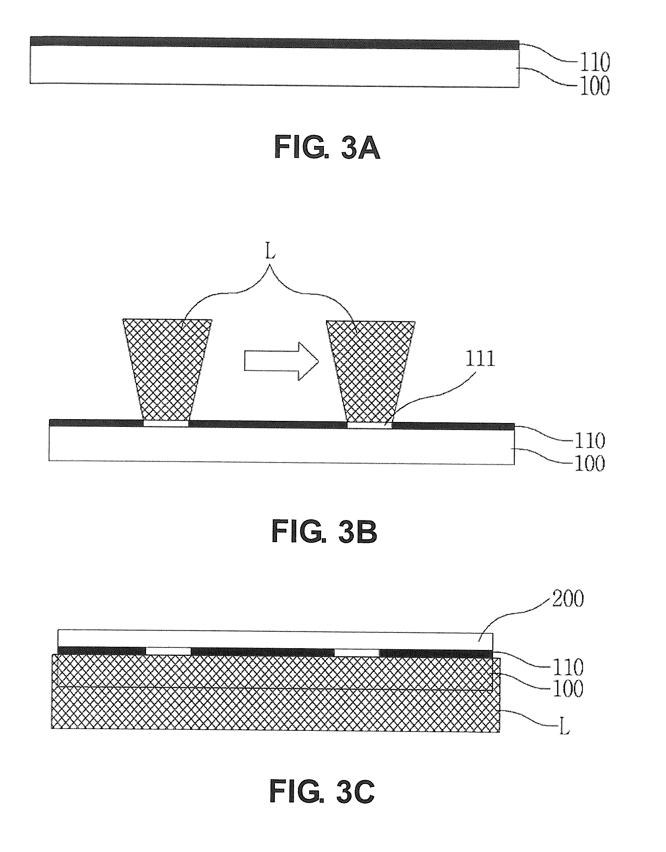

The third step (S120) is a step of patterning the pattern material by irradiating a laser beam to the pattern material in the solid state hardened in the second step (S110). In this case, a pulsed laser is used as a laser beam. The third step(S120) peels a specific part of the pattern material (namely, a part irradiated by a laser beam) using the pulsed laser to pattern the pattern material. A positive type will be described in detail with reference to FIG. 3a to FIG. 3d.

The fourth step (S130) is a step of pressing pattern material in the solid state patterned in the third step (S120) and a flexible substrate 200 facing each other, and then transferring the patterned pattern material to the flexible substrate 200 by a viscous force of the flexible substrate 200 occurring in a facing part between the pattern material and the flexible substrate 200 by irradiating the non-focused laser beam from the pattern material to the flexible substrate 200 or from the flexible substrate 200 to the pattern material. In this case, the flexible substrate 200 includes a polymer material. The polymer material means plastic (e.g. PET). A continuous wave (CW) laser or a pulsed laser can be used as the laser.

Accordingly, according to the pattern transfer method, since transfer material in the solid state is transferred on a flexible substrate 200 directly by a viscous force of the flexible substrate 200 occurred by the irradiation, pattern material can be transferred by a laser with a lower energy compared to a conventional method directly transferring a transfer material in the liquid state and drying.

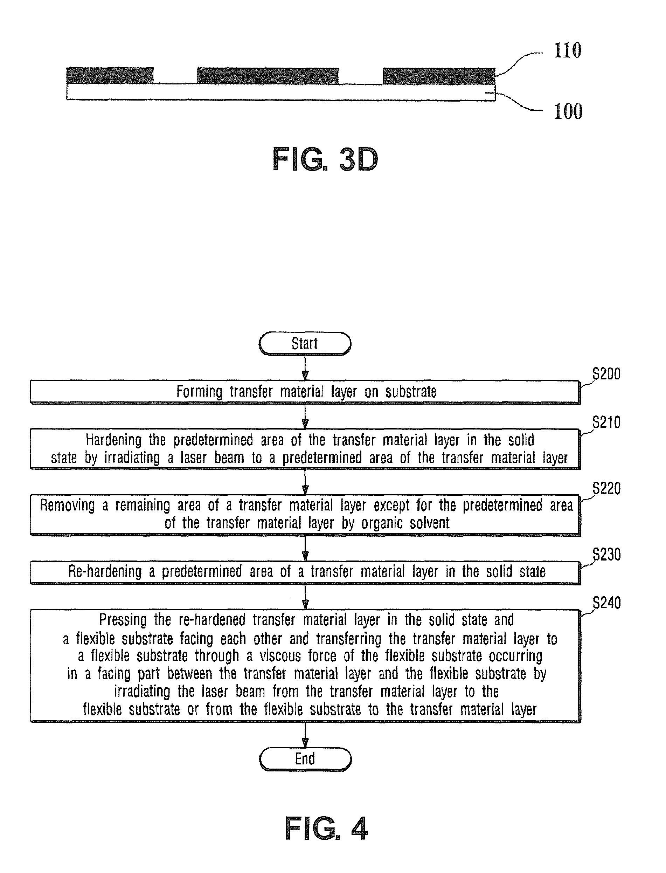

FIG. 3a to FIG. 3d are drawings describing respective steps of the pattern transfer method shown in FIG. 2 pattern transfer method. FIG. 3a to FIG. 3d describe patterning procedures by a positive type. Here, FIG. 3a corresponds to the first step (S100) of FIG. 2, FIG. 3b corresponds to the second step (S110) and the third step (S120) of FIG. 2, FIG. 3c corresponds to the fourth step (S130) of FIG. 2, and FIG. 3d describes a pattern transferred by the pattern transfer method of FIG. 2.

Referring to FIG. 3a, a pattern material 110 is formed on a substrate 100. The pattern material 110 is formed on the substrate 100 using a transfer material such as ink or paste by spin coating, blading coating, slit coating, electro plating, or deposition. In this case, the substrate 100 can be a hard substrate including transparent material such as glass. Since the substrate 100 has a melting point higher than that of a flexible substrate 200 to be described below, it has a characteristic of not being damaged easily by a laser beam L.

Referring to FIG. 3b, a laser beam L is irradiated to the pattern material 110 to pattern the pattern material 110. FIG. 3b describes a procedure of peeling a part of the pattern material 110 irradiated by the laser beam L using a positive type when an opening of a pattern being transferred is not wide. At this time, when a transfer material forming the pattern material 110 is in the liquid state, it is hardened in the solid state using atmosphere or heat. Subsequently, the transfer material is ablated in a moment using a pulsed laser to peel an unnecessary part (namely, parts irradiated by a laser beam). Peeling is adjusted by an output of the laser beam L, moving speed, magnitude of a beam, a repeat speed, and a pulse width. Meanwhile, when the pattern material 110 is formed by electro plating or deposition, it is not needed to harden the pattern material 110.

Referring to FIG. 3c, the patterned pattern material 110 and a flexible substrate 200 are pressed facing each other, and the patterned pattern material 110 is transferred to the flexible substrate 200 by a viscous force of the flexible substrate 200 occurring in a facing part between the pattern material 110 and the flexible substrate 200 by irradiating the laser beam from the pattern material 110 to the flexible substrate 200 or from the flexible substrate 200 to the pattern material 110.

More detailed description is as follows: when a non-focused laser beam L is irradiated to the pattern material 110, because the pattern material 110 has a high heat conductivity, heat is rapidly transferred to a depth direction of the pattern material 110. In this case, because the flexible substrate 200 has a low heat conductivity, heat is accumulated between the flexible substrate 200 and the pattern material 110 due to a difference of heat conductivity between the flexible substrate 200 and the pattern material 110. Accordingly, only the temperature of a surface of the flexible substrate 200 increases to a glass transition temperature in a moment due to the accumulated heat between the flexible substrate 200 and the pattern material 110. In this case, when the surface temperature of the flexible substrate 200 reaches the glass transition temperature, the flexible substrate 200 comes to have strong viscosity, In this case, due to the strong viscosity of the flexible substrate 200, an adhesive force between the flexible substrate 200 and the pattern material 110 becomes stronger than that between the substrate 100 and the pattern material 110. The Ipattern material 110 is transferred on the flexible substrate 200 due to the strong adhesive force between the flexible substrate 200 and the pattern material 110. Then, when cooling is achieved, the characteristic of flexible substrate 200 is restored to the original characteristic. As described above, the shape of the transferred pattern is same as the shape of a pattern patterned on an original substrate 100.

FIG. 4 is a flow chart describing a pattern transfer method according to a second embodiment of the present invention. FIG. 4 shows a negative type remaining a part irradiated by a laser beam when an opening of a pattern is wide to pattern the pattern material. Referring to FIG. 4, a pattern transfer method according to a second embodiment of the present invention includes: a first step of forming a pattern material on a substrate (S200), a second step of hardening the predetermined area of the pattern material in the solid state by irradiating a laser beam to a predetermined area of the pattern material (S210); a third step of removing a remaining area of the pattern material except for the predetermined area of the pattern material by an organic solvent (S220), a fourth step of re-hardening the predetermined area of the pattern material in the solid state (S230), a fifth step of pressing the re-hardened pattern material in the solid state and a flexible substrate 200 facing each other and transferring the pattern material on a flexible substrate 200 by a viscous force of the flexible substrate 200 occurring in a facing part between the pattern material and the flexible substrate 200 by irradiating the laser beam from the pattern material to the flexible substrate 200 or from the flexible substrate 200 to the pattern material (S240),.

The first step (S200) is a step of forming a pattern material on a substrate and coats a hard substrate (hereinafter, it is called as 'substrate')like glass with ink in the liquid state or metal paste. Here, a procedure and a transfer material of forming the pattern material used in the first step (S200) are identical to those of the first step (S200) of FIG. 2, and thus a detailed explanation thereof is omitted. Also, although not shown, the first step (S200) may further include a step of forming a parting layer on the substrate before formation of the pattern material on the substrate. At this time, the parting layer helps the pattern material on the substrate to be separated from the substrate and transferred to the flexible substrate 200

The second step (S210) is a step of hardening the predetermined area of the pattern material in the solid state by irradiating a laser beam to a predetermined area of the pattern material. Here, the predetermined area is an area to be remained since it is irradiated by the laser beam. Further, a continuous wave (CW) laser is used as the laser beam. The second step (S210) selectively heat-hardens the predetermined area of the pattern material using the CW layer.

The third step (S220) is a step of removing a remaining area of the pattern material except for the predetermined area of the pattern material heat-hardened at the second step (S210) by organic solvent. In this case, there is a solvent of a transfer material in the liquid state or an acetone as an example of the organic solvent. The third step (S220) is a step of washing the remaining area of the pattern material except for the predetermined area thereof using the organic solvent.

The fourth step (S230) is a step of re-hardening and drying a predetermined area of the pattern material in the solid state. The fourth step (S230) hardens the predetermined area of the pattern material in the solid state in atmosphere. Since an organic solvent may penetrate in the predetermined area of the pattern material to liquidize a surface thereof at the third step (S220), the fourth step (S230) re-hardens or dries the predetermined area of the pattern material. Moreover, when a transfer material forming the pattern material is in the liquid state, the fourth step (S230) may hardens the transfer material in the solid state in such way that applying heat from 50°C to 200°C to the transfer material in the liquid state, thereby only liquid state solvents being vaporized and then, solid state nano-particles therein being remained.

The fifth step (S240) is a step of pressing the re-hardened pattern material in the solid state and a flexible substrate 200 facing each other and transferring the Ipattern material on a flexible substrate 200 by a viscous force of the flexible substrate 200 occurring in a facing part between the pattern material and the flexible substrate 200 by irradiating the laser beam from the pattern material to the flexible substrate 200 or from the flexible substrate 200 to the pattern material.

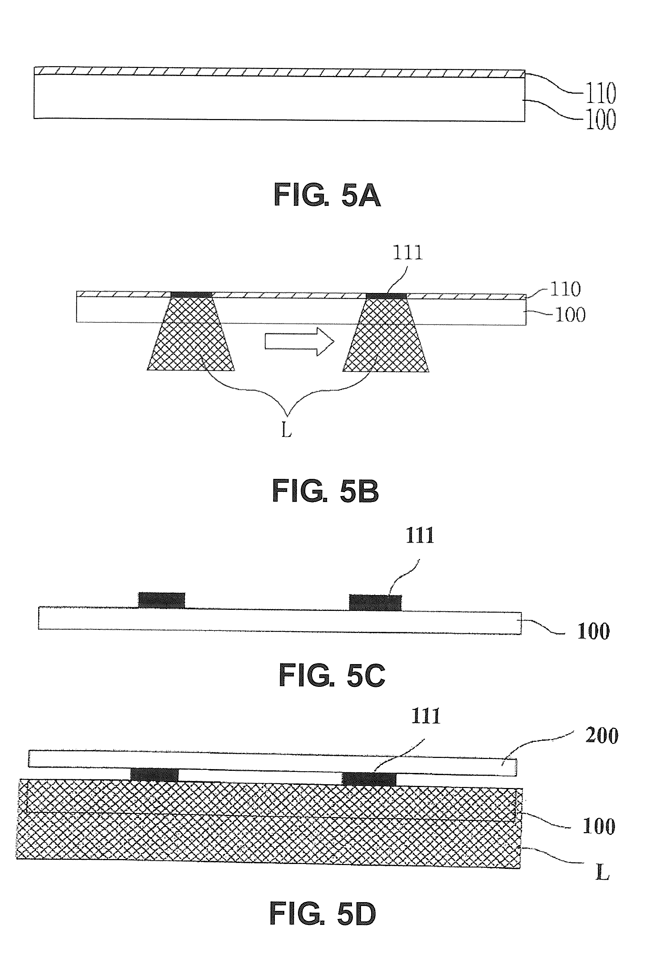

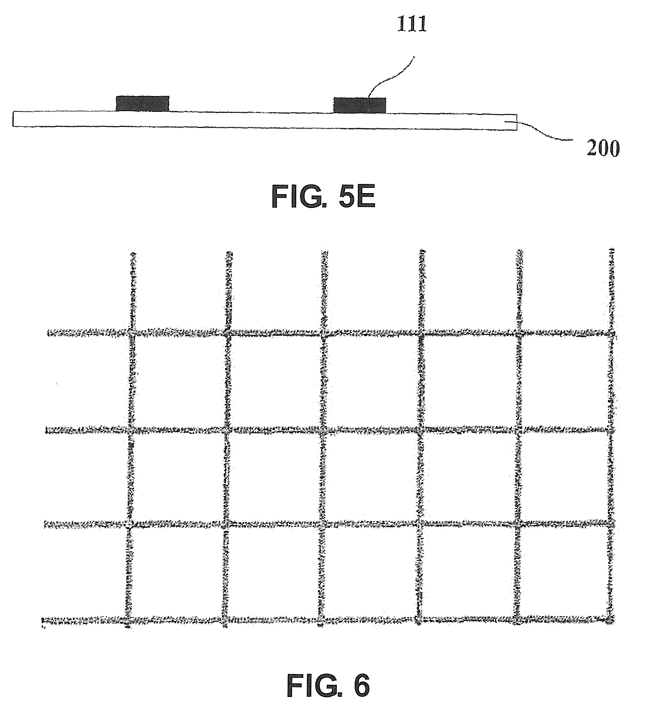

FIG. 5a to FIG. 5e are drawings describing respective steps of the pattern transfer method shown in FIG. 4. Further, FIG. 5a to FIG. 5e describe a patterning method using a negative type. FIG. 5a corresponds to the first step (S200) of FIG. 4, FIG. 5b corresponds to the second step (S210) of FIG. 4, FIG. 5c corresponds to the third step (S220) and the fourth step (S230) of FIG. 4, FIG. 5d corresponds to the fifth step (S240) of FIG. 4, and FIG. 5e describes a pattern transferred by the pattern transfer method of FIG. 4. Since FIG. 5a to FIG. 5e are identical to FIG. 3a to FIG. 3d except for a patterning method, only FIG. 5b and FIG. 5c will be described.

Referring to FIG. 5b, a laser beam L is irradiated to a predetermined area 111 of a pattern material 110 to harden the predetermined area 111 of a pattern material 110. FIG. 5 describes a procedure of remaining the predetermined area 111 of a pattern material 110 irradiated by the laser beam L using a negative scheme when an opening of a pattern being transferred is wide. At this time, when a transfer material forming the pattern material 110 is in the liquid state, it is locally and selectively hardened using the CW laser before hardening. Subsequently, as shown in FIG. 5c, remaining parts of the pattern material 110 except for the locally hardened part are washed with a customized washing agent (namely, organic solvent) to form a pattern with a big opening. In this case, hardening is adjusted by an output of the laser beam L, moving speed, and magnitude of the laser beam L.

According to the pattern transfer method, pattern material in the solid state patterned on a substrate 100 and a flexible substrate 200 are pressed facing each other, and the pattern material 110 is transferred to a flexible substrate 200 by a viscous force of the flexible substrate occurring in a facing part between the pattern material 110 and the flexible substrate 200 by irradiating a laser beam L, thereby the boundary of the transferred pattern is clear, and a pattern can be formed uniformly on a large area.

FIG. 6 is a drawing describing a pattern transferred on a flexible substrate 200 using the pattern transfer method shown in FIG. 2. FIG. 6 describes a silver ink pattern transferred on a flexible substrate 200 using the pattern transfer method of FIG. 2. Referring to FIG. 6, boundary of the silver ink pattern formed by the pattern transfer method of FIG. 2 is clear, and the pattern is uniformly formed.

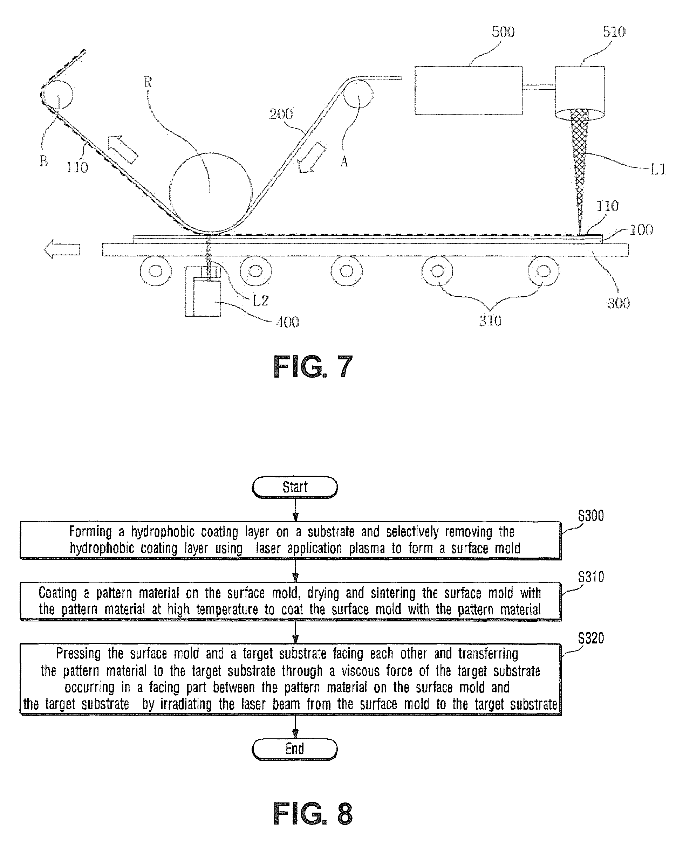

FIG. 7 is a drawing describing a pattern transfer apparatus according to a third embodiment of the present invention. Referring to FIG. 7, a pattern transferring apparatus according to a third embodiment of the present invention comprises a flexible substrate 200, a substrate 100, a moving unit 300, and a laser irradiating unit 400. FIG. 7 describes an example of a patterning a pattern material 110 using a positive type.

The flexible substrate 200 is made of a polymer material, and one side of the flexible substrate 200 is wound around a roll R. Both sides of the flexible substrate 200 may be wound around two rolls A and B to move in a direction of an arrow. A filler or a cushion material may be provided between the roll R and one side of the flexible substrate 200 to improve contact between the flexible substrate 200 and the substrate 100.

The substrate 100 is disposed to be pressed facing a lower portion of the flexible substrate 200, and a pattern material 110 formed on an upper surface of the substrate 100 is hardened to a solid state in atmosphere. Further, when a transfer material forming the pattern material 110 formed on the substrate 100 is in the liquid state, heat from 50°C to 200°C is applied to the transfer material in the liquid state to harden the transfer material in a in the solid state in such a way that only solvents in the liquid state are vaporized and nano-particles in the solid state remain. Consequently, the pattern material 110 is patterned by a laser source 500 and a laser beam L1 irradiated from a scanner 510. The pattern material 110 patterned on the substrate 100 is transferred on the flexible substrate 200 by operation of the moving unit 300. Meanwhile, it is preferred that the substrate 100 is a transparent substrate like glass to penetrate the irradiated laser beam L1. In this case, the laser beam L1 is irradiated by a CW laser scheme and a pulsed laser scheme.

The moving unit 300 is disposed at a lower surface of the substrate 100 and moves the substrate 100. In this case, the moving unit 300 moves the substrate 100 to press the flexible substrate 200 and the substrate 100 facing each other. A roller 310 is installed at a lower bottom of the moving unit 300 to move the location of moving unit 300 easily. Since the pattern transferring apparatus moves the substrate 100 using the moving unit 300 to transfer a pattern, a large-area pattern can be transferred.

The laser irradiating unit 400 irradiates a laser beam L2 as a line beam form from the pattern material 110 to the flexible substrate 200 or from the flexible substrate 200 to the pattern material 110. At this time, as the substrate 100 is moved by the moving unit 300, the patterned pattern material 110 in the solid state is transferred to the flexible substrate 200 by a viscous force of the flexible substrate 200 occurring in a facing part between the pattern material 110 and the flexible substrate 200 by irradiation of the laser beam L2. At this time, the laser beam L2 irradiated by the laser irradiating unit 400 heats only the transfer material patterned on the substrate 100 corresponding to a facing part between the flexible substrate 200 and the substrate 100. Then, heat is accumulated between a transfer material having higher heat conductivity and a flexible substrate 200 having relatively lower heat conductivity.

At this time, due to heat accumulated at the facing part between the flexible substrate 200 and the substrate 100, when a temperature of the flexible substrate 200 increases to a glass transition temperature, the flexible substrate 200 comes to have strong viscosity, and the transfer material is transferred on the flexible substrate 200 due to the strong viscosity of the flexible substrate 200. Meanwhile, the laser irradiating unit 400 irradiates a line beam laser to the facing part between the flexible substrate 200 and the substrate 100. Furthermore, power and an irradiating area of the laser beam L2 and moving speed of the moving unit 300 can be controlled according to characteristics of the transfer material.

Meanwhile, CW laser type can be used as an irradiation type of laser beam L2 in the pattern transfer apparatus. Here, the CW laser type radiates a laser through population inversion from a resonator in the laser.

As described above, according to the pattern transfer apparatus, because the transfer material is directly transferred in the solid state, a boundary of a pattern may be improved and a high slenderness ratio may be implemented. Furthermore, since the pattern transfer apparatus may transfer a transfer material on a flexible substrate200 and such a process can be performed as a continuous process, products can be manufactured rapidly and cheaply. And a density of an electrode wire is denser than that of a conventional type, a performance of a product can be improved.

A pattern transferred by the foregoing pattern transfer method and pattern transfer apparatus is applicable when an electrode wire of a flexible display panel, an electrode wire of a touch panel, an electrode wire of a flexible solar cell, an electrode wire of a portable device such as an electronic book, a pattern of an electromagnetic-shielding sheet, a gate electrode, a source electrode, and a drain electrode of a thin film transistor, and a conductive wire of a flexible PCB are formed.

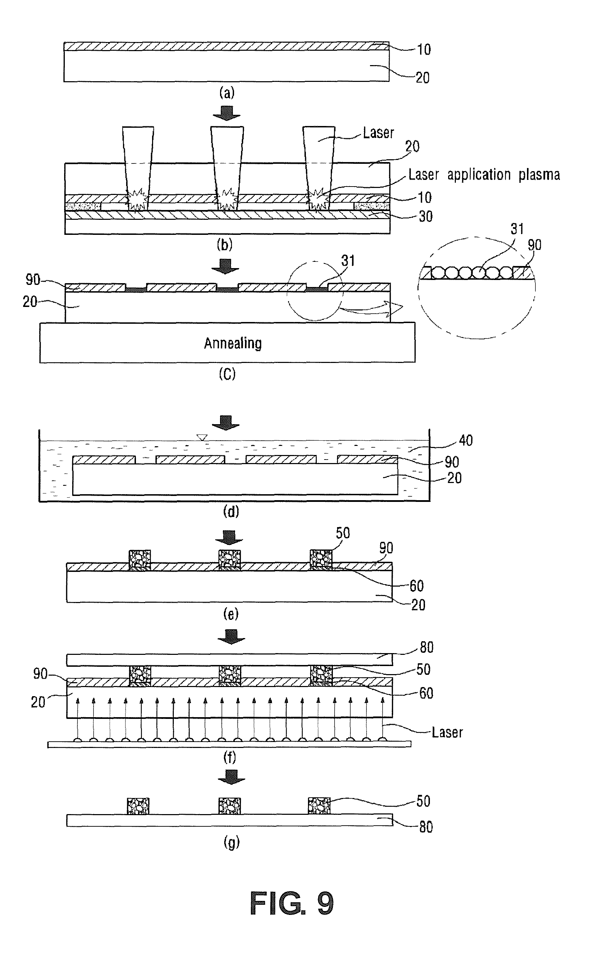

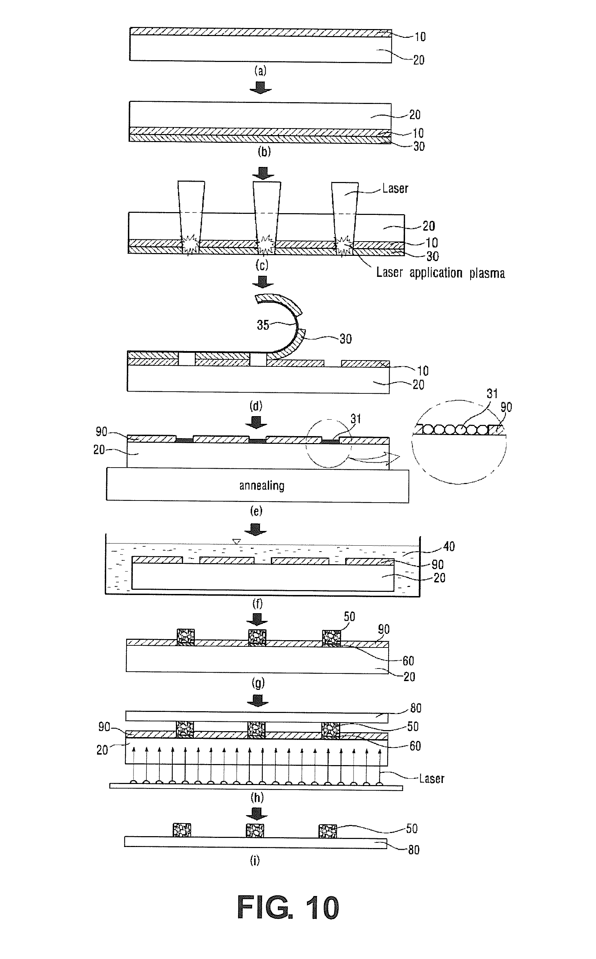

FIG. 8 is a flow chart describing a pattern transfer method according to a fourth embodiment of the present invention; FIG. 9 is a view illustrating a series of procedures transferring a pattern according to a fourth embodiment of the present invention; and FIG. 10 is a view illustrating a principle that a pattern material 50 is transferred from a substrate 20 to a flexible substrate according to a fourth embodiment of the present invention.

In the meantime, the substrate 20 is easily coated with a hydrophobic coating layer. It is preferred that the substrate 20 is a substrate such as glass having excellent thermal resistance and light transmission. However, the present invention is not limited thereto. For example, the substrate 20 is made by materials having a transparent material capable easily transmitting laser of high temperature.

A pattern transfer method will be described with reference to FIG. 8 to FIG. 11.

Referring to FIG. 8, a pattern transfer method according to a fourth embodiment of the present invention includes: a first step(S300) of forming a hydrophobic coating layer 10 on a substrate 20 and selectively removing the hydrophobic coating layer 10 using laser application plasma to form a surface mold 90; a second step(S310) of forming a pattern by providing and drying a pattern material 50 on the surface mold 90, and then by sintering the surface mold 90 at a high temperature; a third step(S320) of pressing the surface mold 90 and a target substrate 80 facing each other and transferring the pattern material 50 to the target substrate 80 by a viscous force of the target substrate 80 occurring in a facing part between the pattern material 50 on the surface mold 90 and the target substrate 80 by irradiating the laser beam from the surface mold 90 to the target substrate 80.

In the first step(S300), a hydrophobic Self-Assembled Monolayers (referred to as 'SAM' hereinafter) is coated on a hard substrate 200 such glass.

To describe the hydrophobic coating layer 10, the SAM layer is explained as an example thereof. Accordingly, reference numeral 10 refers to the SAM layer hereinafter.

The SAM layer can be formed by liquid manufacturing or vapor deposition scheme and implemented by tridecafluoro-1,1,2,2-tetrahydrooctyltrichlorosilane (FOTS).

Next, the SAM layer coated on the substrate 20 is selectively removed using laser application plasma to form a surface mold 90. In general, because the SAM layer 10 is transparent, it does not react with typical laser. Consequently, the typical laser cannot remove the SAM layer 10.

In spite of such a difficulty, to manufacture the surface mold 90, a fourth embodiment of the present invention uses a method removing the SAM layer 10 using laser application plasma.

In detail, the method of the fourth embodiment means a method that selectively removes the SAM layer 10 coated on the substrate 20 using plasma produced when irradiating laser to a specific material. The method removing the SAM layer 10 using laser application plasma is easily understood with reference to FIG. 9(b). After a plasma generation layer 30 is formed on the substrate 20 coated with the SAM layer 10 to be spaced apart therefrom, laser is irradiated to a substrate of an opposite side to a side coated with the SAM layer 10 to cause the laser penetrating the substrate 20 and the SAM layer and reaching the plasma generation layer 30.

When the laser reaches the plasma generation layer 30, plasma is generated between the SAM layer 10 and the plasma generation layer 30. The plasma selectively removes the SAM layer 10. At this time, the SAM may be removed due to an interval between the SAM layer 10 and the plasma generation layer 30, a focus size of laser, output of the laser, pulse width, pulse repetition rate, moving speed of the laser focus to change a peeling area. Because the SAM is momently removed due to strong plasma plume, it can be removed in the size finer than a laser spot size by adjusting the size and the interval of plasma. There is a continuous wave (CW) laser or a plulsed laser as an example of laser used at this time. In general, the plasma generation layer 30 is achieved by metal. Besides metal, the plasma generation layer 30 can be made by certain material capable of generating plasma at the time of reacting with laser.

When the laser application plasma is generated, particles of the plasma generation layer 30 are dispersed to the surface mold 90. When the plasma generation layer 30 is made by metal, metal particles are dispersed. If leaving the metal particles, the surface mold 90 is rough and uniformity and quality of the surface mold 90 are deteriorated. Accordingly, there is a need to remove the metal particles. Accordingly, it is preferred that the first step(S300) further includes a step of removing a particle 31 of a plasma generation layer dispersed on the substrate. As a simple method for removing a metal particle, a method putting a substrate 20 coated with the SAM layer 10 in acidic solution such as hydrogen Chloride (HCl) is illustrated in FIG. 9(d). A soak time can range from several seconds to several tens seconds according to the type and concentration of a used acid.

A method using acidic solution is suggested as a method removing a particle 31 of the plasma generation layer. Besides this, some methods capable of removing a particle 31 of the plasma generation layer may be used. For example, ultrasonic cleaning or injection of cleaning solution 40 can remove the particles 31 of the plasma generation layer. The foregoing methods can be used. Further, it is easily understood that a person having ordinary skill in the art can remove a particle 31 of the plasma generation layer by ultrasonic cleaning or injection of cleaning solution 40.

To prevent damage of the SAM layer 10 formed on the substrate 20 before removal of the particle 31 of the plasma generation layer, it is preferable to anneal the substrate 20 on which the SAM layer 10 is formed at high temperature. The annealing step can be known with reference to FIG. 9(c). However, the particles can not exist according to an irradiation condition of laser. In this case, the first step(S300) need not include a step of removing the particles 31 of the plasma generation layer.

The first step is composed of the following four steps that is, a step of forming a SAM layer 10, for example, FOTS (tridecafluoro-1,1,2,2-tetrahydrooctyltrichlorosilane) on a hard substrate 20 like glass by using a liquid preparation method or a vapor deposition method, a step of coating the SAM layer 10 with the plasma generation layer 30 made of a material like metals capable of generating plasma during the reaction with laser, a step of generating plasma by irradiating the laser from the substrate to the plasma generation layer 30, and selectively removing by plasma the SAM layer 10 formed in a predetermined area, and a step of removing by using a coupling force difference, the plasma generation layer 30 which is not strongly coupled to the SAM layer 10 by attaching an adhesive tape 35 to and removing the adhesive tape 35 from the plasma generation layer 30.

Fig. 10 shows the first step is composed of the aforesaid four steps. Here, the step of forming the SAM layer 10 corresponds to (a) of Fig. 10. The step of coating the plasma generation layer 30 corresponds to (b) of Fig. 10. The step of selectively removing the SAM layer 10 corresponds to (c) of Fig. 10. The step of removing the plasma generation layer 30 through the use of a coupling force difference corresponds to (d) of Fig. 10. It can be said that the rest of (b) to (d) of Fig. 10 are the same as that of Fig. 9.

The second step(S310) is a step of forming a pattern material 50 on the surface mold 90, drying and sintering the surface mold 90 with the pattern material 50 at high temperature to coat the surface mold 90 with the pattern material 50. When the pattern material 50 is transferred to a target substrate 80 on which a pattern is finally transferred in a liquid state, because a boundary of the pattern is infinite, the pattern material 50 is preferably transferred on the target substrate. In particular, when the target substrate 80 is a flexible substrate, thermal resistance of the flexible substrate is low. Accordingly, since there is a limitation of temperature sintering the pattern material, it is preferred that the pattern material 50 is sintered at high temperature to become a solid state and the pattern material 50 in the solid state is finally transferred on the target substrate 80.

When a surface mold 90 soaks in and is separated from a storage tub with the pattern material 50, the pattern material 50 is coated at only a removed part of the SAM layer 10. The pattern material 50 is dried and sintered at high temperature. There is a method using a heating lamp, a hot plate, or a convection oven to dry the pattern material 50. When the surface mold 90 is heated by the heating lamp, the pattern material 50 coated on the surface mold 90 is sintered. Hearing by the heating lamp uses radiant heat. Such a method has a difficulty in setting a desired temperature and heating the substrate while maintaining the temperature. However, the method can perform a continuous process and is profitable to heat the substrate at uniform temperature in comparison with a method using the hot plate or the convection oven.

Heating the substrate 20 uses conduction and heating the substrate 20 by the convection oven uses convection. Such a method has a difficulty in a continuous process and heating the substrate at uniform temperature. However, the method is profitable to set a desired temperature and heating the substrate while maintaining the temperature in comparison with a heating method by a heating lamp using the radiant heat.

It is preferred that the pattern material 50 is a hydrophilic organic metal ink. Moreover, to control a thickness of the pattern, a procedure of coating the surface mold 90 with the pattern material 50 and drying and sintering the pattern material 50 at high temperature can repeat plural times. To obtain a thick pattern, the number of repetitions can be increased. The thickness of the pattern can be controlled by the simple method as mentioned above. FIG. 9(e) illustrates a state of the pattern material coated at only a removed part of the SAM layer 10 and dried and sintered at high temperature.

When an adhesion force of the pattern material 50 to the surface mold 90 is too strong, transfer efficiency can be deteriorated when the pattern is transferred on the target substrate 80 on which the pattern is finally transferred. Accordingly, there is a need to intentionally reduce the adhesion force of the pattern material 50 to the surface mold 90. When the pattern material 50 uses a hydrophilic organic metal ink, after coating the surface mold 90 with weak hydrophobic material such as HMDS or OTS, it is preferred that the surface mold 90 is coated with a hydrophilic organic metal ink and dried and sintered at high temperature. As described above, the pattern is easily transferred on a target substrate 80 on which the pattern is finally transferred by coating the surface mold 90 with weak hydrophobic material, and the quality of a final pattern is improved.

The third step(S320) is a step of pressurizing the surface mold and a target substrate 80 facing each other and transferring the pattern material to the target substrate 80 by a viscous force of the target substrate 80 occurring at a facing part between the pattern material 50 on the surface mold 90 and the target substrate 80 by irradiating the laser beam from the surface mold 90 to the target substrate 80 or from the target substrate to the surface mold.

Referring to FIG. 9(f), a target substrate 80 on which a pattern is finally transferred is pressurized in a state that the target substrate 20 contacts with a transferred surface of the pattern material 50 of a substrate 20 and the surface mold 90 and the target substrate 80 face each other. Here, the surface mold 90 indicates a substrate on which the pattern material 50 is transferred. In this state, laser is irradiated from an opposite surface to a transferred surface of the pattern material 50 of the substrate. In other words, the laser is irradiated from the surface mold 90 to the target substrate 80. However, unlike that shown in FIG. 9(f), the laser can be irradiated from the target substrate 80 to the surface mold 90. When the laser is irradiated, viscous force occurs in the target substrate 80 at a facing part between a pattern material 50 on the surface mold 90 and the target substrate 80. The pattern material 50 is transferred to the target substrate 80 due to viscous force of the target substrate 80.

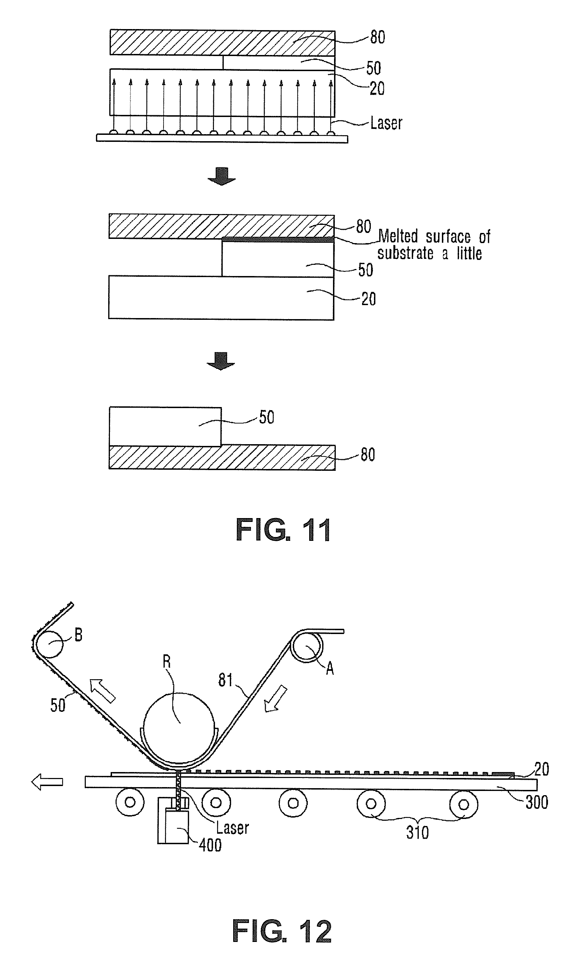

Referring to FIG. 11, a procedure transferring a pattern material 50 on the target substrate 80 by viscous force of the target substrate 80 will be described in detail. When non-focused laser is irradiated from the substrate 20 on which a pattern material 50 is transferred to the target substrate 80 in a state that a target substrate 80 contacts with the target substrate 80 and they are pressurized, because the pattern material 50 has high thermal conductivity, heat is transmitted to a depth direction of the pattern material 50. However, the target substrate 80 has low thermal conductivity, heat is accumulated between the target substrate 80 and the pattern material 50 due to thermal conductivity difference between the target substrate 80 and the pattern material 50. Accordingly, only a surface part of the target substrate 80 momently increases to a glass transition temperature (temperature in which a material rapidly transitions from ductile to brittle) due to heat accumulated between the target substrate 80 and the pattern material 50. At this time, when a surface temperature of the target substrate 80 reaches the glass transition, the target substrate 80 has a high viscosity. In this case, since the target substrate 80 has a high viscosity, an adhesion force between the target substrate 80 and the pattern material 50 is greater than that between the substrate 20 and the pattern material 50. The pattern material 50 is transferred to the target substrate 80 due to a high adhesion force between the target substrate 80 and the pattern material 50. Subsequently, when cooling is executed, the target substrate 80 has an original property. The transferred pattern has the same shape as that of a pattern patterned on an original substrate 20. A final resulting object in a state that transfer is terminated to form a pattern on the target substrate 80 is illustrated in FIG. 9(g). The surface mold 90 in which transfer is terminated is not abandoned but can be reused

FIG. 12 is a view illustrating a pattern transfer apparatus that may continue pattern transfer using a pattern transfer method according to a fourth embodiment of the present invention.

Referring to FIG. 12, a pattern transfer apparatus continuously performing pattern transfer using a pattern transfer method according to the fourth embodiment of the present invention includes a flexible substrate, a substrate 20, a moving unit 300, and a laser irradiating unit 400.

The flexible substrate is made by a polymer material. One side of the flexible substrate is wound by a roll R. Both sides of the flexible substrate are wound by two rollers A and B and it can move in a direction of an arrow. A filler or a cushion material is provided between the roller R and one side of the flexible substrate to improve contact between the flexible substrate and the substrate 20.

The substrate 20 is provided at a lower portion of the flexible substrate to be pressurized facing each other. After an SAM layer 10 is selectively removed at an upper surface of the substrate 20, it is coated with the pattern material 50, and the pattern material is dried and sintered at high temperature. Next, laser is irradiated from the substrate 20 to the flexible substrate or from the flexible substrate to the substrate 20 to transfer the pattern material 50 on the flexible substrate. The pattern material 50 coated on the substrate 20 is continuously transferred on the flexible substrate by operation of the moving unit 300. Meanwhile, it is preferred that the substrate 20 is a transparent substrate 20 such as glass to transmit irradiated laser.

The moving unit 300 is provided at a lower surface of the substrate 20 and moves the substrate 20. At this time, the moving unit 300 moves the substrate 20 to pressurize the flexible substrate and the substrate 20 facing each other. A roller 310 is provided at a lower bottom surface of the moving unit 300 for convenience of movement such that the moving unit 300 can easily move. Since the pattern transfer apparatus moves the substrate 20 using the moving unit 300 to transfer a pattern, pattern transfer of a large area is possible.

The irradiating unit 400 irradiates laser of a line beam form from the pattern material 50 to the flexible substrate, namely, from the substrate 20 to the flexible substrate. At this time, the substrate 20 moves by the moving unit 300 to transfer the pattern material 50 on the flexible substrate due to a viscous force of the flexible substrate occurring at a facing part of the pattern material 50 and the flexible substrate by irradiation of laser. In this case, the laser irradiated from the laser irradiating unit 400 heats only the pattern material 50 on the substrate 20 at a facing part between the flexible substrate and the substrate 20. Accordingly, heat is accumulated between a pattern material 50 with higher thermal conductivity and a flexible substrate with lower thermal conductivity. At this time, when a temperature of the flexible substrate increases to a glass transition temperature due to the heat accumulated at the facing part between the flexible substrate and the substrate 20, the flexible substrate has a high viscosity such that a pattern material 50 is transferred on the flexible substrate due to the high viscosity of the flexible substrate. Moreover, an output and an irradiation area of the laser and moving speed of the moving unit 300 can be controlled according to properties of the pattern material 50.

In the meantime, the pattern transfer apparatus may use a CW laser scheme and a pulsed laser scheme as an irradiating scheme of laser. Here, the CW laser scheme emits laser through population inversion in a resonant in the laser.

As illustrated earlier, in the pattern transfer apparatus, because the pattern material 50 is directly transferred in a solid state, a pattern boundary is improved and a high slenderness ratio can be implemented. Furthermore, because the pattern transfer apparatus may transfer the pattern material 50 on the flexible substrate and such a procedure can be a continuous process, the products can be rapidly at a low cost. Since an electrode wiring can be manufactured to have a concentration finer than that of the related art, the performance of the product can be improved.

The foregoing pattern transfer method has a higher application degree when the target substrate 80 is a flexible substrate. In general, the flexible substrate is made by a polymer material, for example, a PI film. Since most of the polymer material is melted at a temperature of 350°C, a pattern transfer method in which large heat is applied to the flexible substrate is not applicable to the flexible substrate. Accordingly, the pattern transfer method according to a fourth embodiment of the present invention has, in particular, a great application degree to the flexible substrate. In addition, because the pattern material 50 is transferred in a dry sintered state, the size and the quality of a pattern manufactured by the pattern transfer method according to a fourth embodiment of the present invention do not depend on variation in a peripheral environment such as humidity or temperature.

A case which a pattern transfer method according to a fourth embodiment of the present invention will be illustrated.

The electromagnetic shielding sheet is used to prevent an electromagnetic wave from be emitted to an outside because an electromagnetic wave emitted by all type of electronic devices is harmful to a human body. However, among electromagnetic shielding products, because an electromagnetic shielding sheet for display, in particular, for PDP, is adhered to a screen, it should have light transmittance or excellent electromagnetic shielding performance. To have these properties, a metal pattern is formed in a film in a lattice form, which generally has a pattern width of 10 um at an interval of 300 um. The thickness of the metal pattern can vary according to an electromagnetic shielding performance but ranges from several um to several tens um. The electromagnetic shielding sheet uses sputtering up to now. However, since this is a vacuum process, the process is complicated. Further, because the electromagnetic shielding sheet has a large area, there is a limitation to manufacture it at a low cost. Moreover, there is an attempt to manufacture an electromagnetic shielding sheet in a roll to roll process using silver paste. However, there is a big problem to implement a pattern width less than 30 um. Thus, the fourth embodiment of the present invention can be used to the electromagnetic shield sheet with a high yield by a continuous process.

The fourth embodiment of the present invention is also applicable to an electrode wiring of a display/solar cell panel. In particular, an electrode is formed at a surface of a polymer material such as PET to be applicable to form an electrode wiring of a flexible display or a flexible solar cell. In addition, the fourth embodiment is applicable to form a gate electrode, a source electrode, and a drain electrode of a thin film transistor (TFT), and to form an electrode of an electronic book.

Furthermore, the fourth embodiment is applicable to a conductive wiring such as a flexible printed circuit board (FPCB), a Radio-Frequency Identification (RFID) antenna, or a mobile phone antenna. Because a conductive wiring can be formed on a flexible substrate and it may be manufactured by a continuous process, the foregoing products may be rapid manufactured at a low cost. The fourth embodiment may manufacture a wiring having a concentration finer than that of a wiring of the related art to improve the performance of a product. Besides this, the fourth embodiment can manufacture a micro miter pattern of conductive/non-conductive material at a low cost.

In addition, the foregoing products to which the pattern transfer method according to the fourth embodiment of the present invention is applicable can be manufactured using a pattern transfer apparatus capable of continuously performing pattern transfer using the fourth embodiment.

As described above, a technical composition of the present invention is to be understood that a person of ordinary skill in the art is not to modify a technical idea or an essential feature of the present invention but to take effect as the other concrete embodiments.

Therefore, it is to be understood that embodiments described above are not qualifying but exemplary in all points. Also, the scope of the present invention will be included in the following claims than above detail explanation, and it is to be analyzed that the meaning and scope of the claims and all changes deducted from equivalent arrangements or modifications included within the scope of the present invention.

## Claims

1. A pattern transfer method, comprising:
a) a first step (S100) of forming a pattern material (110) on a substrate (100);
a second step (S110) of hardening the pattern material (110) in the solid state;
a third step (S120) of patterning the pattern material (110) by irradiating a laser beam (L) to the hardened pattern material (110) in the solid state; and
a fourth step (S130) of pressing the patterned pattern material (110) in the solid state and a flexible substrate (200) facing each other and transferring the patterned pattern material (110) to the flexible substrate (200) by a viscous force of the flexible substrate occurring in a facing park between the patterned pattern material (110) and the flexible substrate (200) by irradiating the laser beam (L) from the patterned pattern material (110) to the flexible substrate (200) or from the flexible substrate (200) to the patterned pattern material (110);
or
b) a first step (S200) of forming a pattern material (110) on a substrate (100);
a second step (S210) of hardening a predetermined area of the pattern material (110) in the solid state by irradiating a laser beam (L) to the predetermined area of the pattern material; a third step (S220) of removing a remaining area of the pattern material (110) except for the predetermined area of the pattern material by an organic solvent;
a fourth step (S230) of re-hardening the predetermined area of the pattern material in the solid state; and
a fifth step (S240) of pressing the re-hardened pattern material (110) in the solid state and a flexible substrate (200) facing each other and transferring the re-hardened pattern material to the flexible substrate by a viscous force of the flexible substrate occurring in a facing part between the re-hardened pattern material and the flexible substrate by irradiating the laser beam from the re-hardened pattern material to the flexible substrate or from the flexible substrate to the re-hardened pattern material;
or
c) a first step (S300) of forming a hydrophobic coating layer on a substrate and selectively removing the hydrophobic coating layer using laser application plasma to form a surface mold;
a second step (S310) of forming a pattern by coating and drying a pattern material on the surface mold, and then by sintering the surface mold at a high temperature; and
a third step (S320) of pressing the surface mold and a target substrate facing each other and transferring the pattern material to the target substrate by a viscous force of the target substrate occurring in a facing part between the pattern material on the surface mold and the target substrate by irradiating the laser beam from the surface mold to the target substrate or from the target substrate to the surface mold.

2. The pattern transfer method according to claim 1 alternative c), wherein the first step comprises:
a step of forming the hydrophobic coating layer on the substrate (20);
a step of coating a plasma generation layer (30) on the hydrophobic coating layer;
a step of selectively removing the hydrophobic coating layer by irradiating a laser beam from the substrate to the plasma generation layer; and
a step of removing the plasma generation layer.

3. The pattern transfer method according to claim 1 alternative c) or according to claim 2, wherein the pattern material used in the second step is a hydrophilic organic metal ink.

4. A pattern transfer apparatus comprising:
a) a flexible substrate (200, 20) whose one side is wound around a roll and having a polymer material;
a substrate disposed to be pressed facing a lower portion of the flexible substrate, and patterned by a laser beam after a pattern material formed on an upper surface of the substrate is hardened in the solid state;
a moving unit (300) disposed at a lower surface of the substrate and moving the substrate; and
a laser irradiating unit (400) irradiating a laser beam from the moving unit to a direction of the flexible substrate,
wherein the apparatus is configured so that the flexible substrate and the substrate are pressed facing each other as the substrate moves by the moving unit, and the pattern material is transferred to the flexible substrate by a viscous force of the flexible substrate occurred in a facing part between the pattern material and the flexible substrate by the laser beam from the laser irradiating unit;
or
b) a flexible substrate (200, 20) including a polymer material, one side of the flexible substrate wound by a roll;
a substrate coated with a pattern material after selectively removing a hydrophobic coating layer formed on a upper surface of the substrate, and pressurized to face a lower portion of the flexible substrate;
a moving unit (300) provided at a lower surface of the substrate and moving the substrate; and
a laser irradiating unit (400) irradiating laser from the substrate to the flexible substrate or from the flexible substrate to the substrate,
wherein the apparatus is configured so that the moving unit operates to move the substrate, thereby pressurizing the flexible substrate and the substrate to face each other, and the pattern material is transferred on the flexible substrate due to a viscous force of the flexible substrate occurring at a facing part between the pattern material and the flexible substrate by the laser from the laser irradiating unit.

5. The pattern transfer apparatus according to claim 4, alternative a), wherein the laser irradiating unit (400) irradiates a line beam as the laser beam.

6. Pattern, transferred by the pattern transfer method according to any of the claims 1 to 3 and/or by the pattern transfer apparatus according to any of the claims 4 or 5.

7. A flexible display panel comprising an electrode formed by a pattern according to claim 6.

8. A flexible solar cell comprising an electrode formed by a pattern according to claim 6.

9. An electronic book comprising an electrode formed by a pattern according to claim 6.

10. An electromagnetic shielding sheet comprising a pattern according to claim 6.

11. A thin film transistor comprising a gate electrode, a source electrode, and a drain electrode formed by a pattern according to claim 6.

12. A flexible printed circuit board comprising a conductive wiring formed by a pattern transferred by the pattern according to claim 6.

13. Use of the pattern transfer method according to any one of the claims 1 to 3 for transferring a pattern
a) to form an electrode of a flexible display,
b) to form an electrode of a flexible solar cell,
c) to form an electrode of an electronic book,
d) to form a pattern of an electromagnetic shielding sheet;
e) to form a gate electrode, a source electrode, and drain electrode of a thin film transistor; or
f) to form a conductive wiring of a flexible printed circuit board.

14. Use of the pattern transfer apparatus according to any one of the claims 4 or 5 for transferring a pattern
a) to form an electrode of a flexible display,
b) to form an electrode of a flexible solar cell,
c) to form an electrode of an electronic book,
d) to form a pattern of an electromagnetic shielding sheet;
e) to form a gate electrode, a source electrode, and a drain electrode of a thin film transistor; or
f) to form a conductive wiring of a flexible printed circuit board.
